(19) Europäisches Patentamt
European Patent Office
Office européen des brevets

(11) **EP 3 599 476 A1**

(12) **EUROPÄISCHE PATENTANMELDUNG**

(43) Veröffentlichungstag:
**29.01.2020 Patentblatt 2020/05**

(51) Int Cl.:
*G01R 33/561* *(2006.01)*    *G01R 33/48* *(2006.01)*

(21) Anmeldenummer: **18185271.6**

(22) Anmeldetag: **24.07.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Healthcare GmbH**
**91052 Erlangen (DE)**

(72) Erfinder:
• **Paul, Dominik**
  **91088 Bubenreuth (DE)**
• **Carinci, Flavio**
  **91052 Erlangen (DE)**
• **Forman, Christoph**
  **91052 Erlangen (DE)**

(54) **ERFASSEN VON MAGNETRESONANZ-DATEN MITTELS ECHOZÜGEN**

(57)    Die Erfindung betrifft eine Erstellung eines MR-Bildes eines vorbestimmten dreidimensionalen Volumenabschnitts eines Untersuchungsobjekts (13). Dabei werden MR-Daten des Volumenabschnitts mittels Echozügen (2, 3) in einem ersten Schritt und in einem zweiten Schritt erfasst. Jeder der Echozüge (2, 3) erfasst MR-Daten mehrerer K-Raum-Zeilen. Die K-Raum-Zeilen aller Echozüge verlaufen parallel und dabei senkrecht bezüglich einer Ebene, so dass sich pro K-Raum-Zeile ein Schnittpunkt (4; 5) mit dieser Ebene ergibt. Die Anzahl der Schnittpunkte (4) des ersten Schritts ist größer als die Anzahl der Schnittpunkte (5) des zweiten Schritts. Die Menge der Schnittpunkte (5) des ersten Schritts weist eine nicht leere Schnittmenge mit der Menge der Schnittpunkte (4) des ersten Schritts auf. Der mittlere Abstand der Schnittpunkte (5) des zweiten Schritts ist größer als der mittlere Abstand der Schnittpunkte (4) des ersten Schritts. Ausgehend von den MR-Daten wird das MR-Bild rekonstruiert.

FIG 2

EP 3 599 476 A1

**Beschreibung**

Die vorliegende Erfindung betrifft ein Verfahren und eine entsprechend ausgestaltete Magnetresonanzanlage, um MR-Daten in einem vorbestimmten dreidimensionalen Volumenabschnitt mittels mehrerer Echozüge zu erfassen und um anhand der erfassten MR-Daten ein MR-Bild zu rekonstruieren.

Um einen dreidimensionalen Volumenabschnitt mittels mehrerer Echozüge zu erfassen, sind MR-Sequenzen (wie z.B. die SPACE-Sequenz ("Sampling Perfection with Application optimized Contrasts using different flip angle Evolutions") bekannt, bei denen ein selektiver HF-Anregungspuls von einer Folge von nicht-selektiven Refokussierungspulsen gefolgt wird. Der Einsatz von nicht-selektiven Refokussierungspulsen nach einem selektiven HF-Anregungspuls führt jedoch zu FID-Signalen ("Free Induction Decay" bzw. freiem Induktionszerfall) innerhalb des jeweiligen Echozugs aus Bereichen außerhalb des selektiv angeregten Volumens. Dies führt zu sogenannten FID-Artefakten, welche die Bildgebung stören.

Daher stellt sich die vorliegende Erfindung die Aufgabe, MR-Daten eines dreidimensionalen Volumenabschnitts mittels Echozügen zu erfassen und abhängig von diesen MR-Daten ein MR-Bild zu rekonstruieren, wobei vorab erwähnte FID-Artefakte im Vergleich zum Stand der Technik besser vermieden werden können.

Erfindungsgemäß wird diese Aufgabe durch ein Verfahren zur Erstellung eines MR-Bildes eines vorbestimmten dreidimensionalen Volumenabschnitts eines Untersuchungsobjekts nach Anspruch 1, durch eine Magnetresonanzanlage nach Anspruch 13, durch ein Computerprogrammprodukt nach Anspruch 15 und durch einen elektronisch lesbaren Datenträger nach Anspruch 16 gelöst. Die abhängigen Ansprüche definieren bevorzugte und vorteilhafte Ausführungsformen der vorliegenden Erfindung.

Im Rahmen der vorliegenden Erfindung wird ein Verfahren zur Erstellung eines MR-Bildes eines vorbestimmten dreidimensionalen Volumenabschnitts eines Untersuchungsobjekts bereitgestellt. Dabei werden MR-Daten des Volumenabschnitts mit Hilfe von Echozügen in einem ersten Schritt und in einem zweiten Schritt erfasst. Ausgehend von diesen MR-Daten wird das MR-Bild rekonstruiert. Jeder der Echozüge (aus dem ersten Schritt und aus dem zweiten Schritt) erfasst dabei MR-Daten mehrerer K-Raum-Zeilen. Dabei verlaufen die K-Raum-Zeilen aller Echozüge parallel zueinander und senkrecht zur selben Ebene. Daher weist jede K-Raum-Zeile genau einen Schnittpunkt mit dieser Ebene auf. Die Anzahl dieser Schnittpunkte des ersten Schrittes ist dabei größer als die Anzahl der Schnittpunkte des zweiten Schrittes. Mit anderen Worten werden während des ersten Schrittes mehr K-Raum-Zeilen abgetastet als während des zweiten Schrittes. Die Menge der Schnittpunkte des zweiten Schrittes weist eine nicht leere Schnittmenge mit der Menge der Schnittpunkte des ersten Schrittes auf. Das heißt, dass zumindest eine K-Raum-Zeile existiert, deren MR-Daten sowohl während des ersten Schrittes als auch während des zweiten Schrittes erfasst werden. Dabei ist der mittlere Abstand der (benachbarten) Schnittpunkte des zweiten Schrittes größer als der mittlere Abstand der (benachbarten) Schnittpunkte des ersten Schrittes. Dieses letzte Merkmal ist gleichbedeutend mit dem Merkmal, dass die mittlere Dichte der Schnittpunkte für den ersten Schritt größer als für den zweiten Schritt ist. Mit anderen Worten liegen die (benachbarten) Schnittpunkte des zweiten Schrittes im Mittel weiter auseinander als die Schnittpunkte des ersten Schrittes.

Dabei kann die mittlere Dichte wie folgt definiert werden. Wenn die Schnittfläche des K-Raums mit der Ebene schachbrettartig in mehrere (z.B. 100) gleichgroße Flächenteile aufgeteilt wird, dann ist für jedes derjenigen Flächenteile, in welchen sich mehr als eine vorbestimmte Anzahl (z.B. 3 oder 10) Schnittpunkte des zweiten Schritts befindet, die Anzahl der Schnittpunkte des ersten Schrittes größer als die Anzahl der Schnittpunkte des zweiten Schrittes. Anders ausgedrückt existiert kein Flächenteil mit zumindest der vorbestimmten Anzahl von Schnittpunkten des zweiten Schritts, für welches die Anzahl der Schnittpunkte des ersten Schritts gleich oder gar kleiner als die Anzahl der Schnittpunkte des zweiten Schritts ist.

In jedem Schritt (d.h. sowohl im ersten Schritt als auch im zweiten Schritt) werden K-Raum-Zeilen mittels Echozügen abgetastet. Ein bestimmter Schnittpunkt einer K-Raum-Zeile kann dann demjenigen Schritt (d.h. dem ersten oder zweiten Schritt) zugeordnet werden, während welchem die entsprechende K-Raum-Zeile abgetastet wird. Ein Schnittpunkt des ersten bzw. zweiten Schrittes ist demnach ein Schnittpunkt, welchen eine K-Raum-Zeile, welche während des jeweiligen Schrittes abgetastet wird, mit der vorab beschriebenen Ebene ausbildet.

Indem erfindungsgemäß der K-Raum mit zwei Schritten abgetastet wird, wird der K-Raum in gewisser Weise zweimal erfasst. Dabei wird der K-Raum während des ersten Schrittes derart erfasst, dass anhand der im ersten Schritt erfassten MR-Daten Verfahren wie Compressed Sensing, CAIPIRINHA (Controlled Aliasing in Parallel Imaging Results in Higher Acceleration) und GRAPPA (GeneRalized Autocalibrating Partially Parallel Acquisition) ein MR-Bild rekonstruieren können. Mit anderen Worten wird erfindungsgemäß im ersten Schritt der K-Raum insbesondere in dem Sinn vollständig abgetastet, dass alle Informationen zur Rekonstruktion eines MR-Bildes vorhanden sind. Die Erfindung umfasst dabei auch die Möglichkeit, dass der K-Raum während des ersten Schrittes im wörtlichen Sinn vollständig abgetastet wird (also jeder K-Raum-Punkt des K-Raums erfasst wird).

Im zweiten Schritt wird der K-Raum (im Vergleich zum ersten Schritt) teilweise nochmals abgetastet, so dass beispielsweise ein bestimmter Anteil von 40% bis nahezu 100%

des K-Raums doppelt aufgenommen wird.

Für die zeitliche Reihenfolge, in welcher die Echozüge des ersten Schritts und die Echozüge des zweiten Schritts erfasst werden, existieren erfindungsgemäß folgende Varianten:

1. Als erste Variante können alle Echozüge des ersten Schrittes vor den Echozügen des zweiten Schrittes aufgenommen werden. Das heißt, der erste Schritt liegt zeitlich vollständig vor dem zweiten Schritt. Somit folgt der zweite Schritt zeitlich dem ersten Schritt.

2. Quasi als Umkehrung der ersten Variante können alle Echozüge des zweiten Schrittes vor den Echozügen des ersten Schrittes aufgenommen werden. Das heißt, der zweite Schritt liegt zeitlich vollständig vor dem ersten Schritt. Somit folgt der erste Schritt zeitlich dem zweiten Schritt.

3. Es ist allerdings auch möglich, dass die Echozüge des ersten Schrittes und die Echozüge des zweiten Schrittes zueinander verschachtelt aufgenommen werden. Das bedeutet, dass zwischen dem ersten und dem letzten Echozug des ersten Schrittes zumindest ein Echozug des zweiten Schrittes aufgenommen wird und dass auch zwischen dem ersten und dem letzten Echozug des zweiten Schrittes zumindest ein Echozug des ersten Schrittes aufgenommen wird. Somit werden die Echozüge des ersten Schrittes und des zweiten Schrittes zeitlich verschachtelt erfasst. Häufig wird diese dritte Variante derart realisiert, dass zumindest ein Echozug des ersten (zweiten) Schrittes aufgenommen wird, dann zumindest ein Echozug des zweiten (ersten) Schrittes aufgenommen wird, dann wieder zumindest ein Echozug des ersten (zweiten) Schrittes aufgenommen wird, usw.. Das heißt, zu einem beliebigen Zeitpunkt während des Erfassens der Echozüge des ersten und zweiten Schrittes ist der Prozentsatz der zu diesem Zeitpunkt erfassten Echozüge des ersten Schrittes ungefähr gleich dem Prozentsatz der zu diesem Zeitpunkt erfassten Echozüge des zweiten Schrittes.

Der mittlere Abstand der Schnittpunkte des zweiten Schrittes ist dabei insbesondere um einen Abstandsfaktor größer als der mittlere Abstand der Schnittpunkte des ersten Schrittes. Dieser Abstandsfaktor ist dabei umso größer, je größer das Verhältnis zwischen der Anzahl der Schnittpunkte des ersten Schrittes zu der Anzahl der Schnittpunkte des zweiten Schrittes ist. Wenn also beispielsweise bei einer ersten Ausführungsform im zweiten Schritt 40 % der K-Raum-Zeilen des ersten Schrittes abgetastet werden und bei einer zweiten Ausführungsform im zweiten Schritt 60 % der K-Raum-Zeilen des ersten Schrittes abgetastet werden, ist der Abstandsfaktor (und damit der mittlere Abstand zwischen den Schnittpunkten des zweiten Schrittes im Vergleich zum ersten Schritt) bei der ersten Ausführungsform größer als bei der zweiten Ausführungsform. Gleiches gilt auch für die mittlere Dichte der Schnittpunkte. Das heißt, die mittlere Dichte der Schnittpunkte des ersten Schrittes ist insbesondere um einen Dichtefaktor größer als die mittlere Dichte der Schnittpunkte des zweiten Schrittes, wobei dieser Dichtefaktor umso größer ist, je größer das Verhältnis zwischen der Anzahl der Schnittpunkte des ersten Schrittes zu der Anzahl der Schnittpunkte des zweiten Schrittes ist.

Erfindungsgemäß können zur Abtastung des K-Raums (beim ersten Schritt und/oder beim zweiten Schritt) verschiedene Reordering-Verfahren eingesetzt werden. Dabei beschreibt das eingesetzte Reordering-Verfahren, welche K-Raum-Zeilen in welcher Reihenfolge von einem Echozug abgetastet werden. Erfindungsgemäß können als Reordering-Verfahren eingesetzt werden:

• lineares Reordering

Beim linearen Reordering verläuft eine Linie der Schnittpunkte (mit der oben genannten Ebene) derjenigen K-Raum-Zeilen, welche vom jeweiligen selben Echozug abgetastet werden, parallel zur ky-Achse oder zur kz-Achse. Dabei bilden die kx-Achse, ky-Achse und die kz-Achse das Koordinatensystem des K-Raums, wobei jede K-Raum-Zeile parallel zur kx-Achse liegt.

• radiales Reordering

Beim radialen Reordering verläuft die Linie der Schnittpunkte derjenigen K-Raum-Zeilen, welche vom jeweiligen (selben) Echozug abgetastet werden, vom Zentrum des K-Raums radial nach außen oder umgekehrt (d.h. von außen radial zum Zentrum des K-Raums).

• Wedge-Reordering

Beim Wedge-Reordering verläuft die Linie der Schnittpunkte derjenigen K-Raum-Zeilen, welche vom jeweiligen (selben) Echozug abgetastet werden, von der Nähe des K-Raum-Zentrums über das K-Raum-Zentrum und von dort radial nach außen oder umgekehrt (d.h. von außen radial über K-Raum-Zentrum bis zu einem Schnittpunkt in der Nähe des K-Raum-Zentrums).

Um bestimmte Kontraste in dem aus den MR-Daten rekonstruierten MR-Bild realisieren zu können, wird häufig erfindungsgemäß das radiale Reordering oder das Wedge-Reordering eingesetzt.

Indem erfindungsgemäß zumindest ein Teil des K-Raums doppelt abgetastet wird und da der mittlere Abstand der Schnittpunkte im zweiten Schritt größer als der mittlere Abstand der Schnittpunkte im ersten Schritt ist, können die FID-Artefakte nahezu komplett oder zumindest besser als nach dem Stand der Technik unterdrückt werden.

Gemäß einer bevorzugten erfindungsgemäßen Ausführungsform wird während des ersten Schrittes ein zentraler Teil des K-Raums vollständig (d.h. jeder K-Raum-Punkt dieses zentralen Teils) abgetastet. Dabei bildet das K-Raum-Zentrum insbesondere auch das Zentrum des zentralen Teils, welcher beispielsweise 100 bis 1000 Schnittpunkte (d.h. K-Raum-Zeilen) umfasst.

Indem der zentrale Teil des K-Raums während des ersten Schrittes vollständig erfasst wird, kann die Qualität des rekonstruierten MR-Bildes verbessert werden.

Bezüglich der Abtastung des zentralen Teils des K-Raums existieren erfindungsgemäß zwei Varianten:

- Die K-Raum-Punkte des zentralen Teils des K-Raums werden mit Hilfe von Echozügen erfasst, welche ausschließlich K-Raum-Punkte bzw. MR-Daten dieses zentralen Teils erfassen. Mit anderen Worten erfassen die Echozüge, welche den zentralen Teil erfasst, keine K-Raum-Punkte außerhalb dieses zentralen Teils.

- Die K-Raum-Punkte des zentralen Teils des K-Raums werden mit Hilfe von Echozügen erfasst, welche nicht nur K-Raum-Punkte bzw. MR-Daten dieses zentralen Teils, sondern auch K-Raum-Punkte bzw. MR-Daten außerhalb dieses zentralen Teils des K-Raums erfassen. Mit anderen Worten beginnt und/oder endet ein Echozug, welcher MR-Daten des zentralen Teils des K-Raums erfasst, vor bzw. nach dem zentralen Teil, um auch MR-Daten vor bzw. nach dem zentralen Teil zu erfassen.

Erfindungsgemäß kann der zentrale Teil des K-Raums auch während des zweiten Schritts vollständig erfasst werden. Auch zum Erfassen der K-Raum-Punkte des zentralen Teils des K-Raums kann eine der vorab beschriebenen beiden Varianten eingesetzt werden.

Bezüglich der Beziehung zwischen der Menge der Schnittpunkte des ersten Schrittes und der Menge der Schnittpunkte des zweiten Schrittes existieren erfindungsgemäß folgende Varianten:

1. Die Menge der Schnittpunkte des zweiten Schrittes kann eine Teilmenge der Menge der Schnittpunkte des ersten Schrittes sein. Bei dieser Variante wird also jede K-Raum-Zeile, welche während des zweiten Schrittes abgetastet wird, auch während des ersten Schrittes abgetastet.

2. Die Menge der Schnittpunkte des zweiten Schrittes unterscheidet sich nur außerhalb des zentralen Teils des K-Raums von der Menge der Schnittpunkte des ersten Schrittes. Bei dieser Variante werden innerhalb des zentralen Teils im zweiten Schritt dieselben K-Raum-Zeilen abgetastet wie im ersten Schritt. Nur außerhalb des zentralen Teils werden im zweiten Schritt K-Raum-Zeilen abgetastet, welche im ersten Schritt nicht abgetastet werden.

3. Erfindungsgemäß ist es allerdings auch möglich, dass die Beziehung zwischen der Menge der Schnittpunkte des ersten Schrittes und der Menge der Schnittpunkte des zweiten Schrittes weder der ersten noch der zweiten Variante entspricht. Bei dieser Variante gilt nur, dass zumindest eine K-Raum-Zeile sowohl während des ersten Schrittes als auch während des zweiten Schrittes abgetastet wird.

Zur Rekonstruktion des MR-Bildes abhängig von den im ersten und zweiten Schritt erfassten MR-Daten existieren erfindungsgemäß folgende Varianten:

- Die im ersten Schritt erfassten MR-Daten und die im zweiten Schritt erfassten MR-Daten werden addiert. Das heißt, dass für diejenigen K-Raum-Punkte, für welche sowohl im ersten als auch im zweiten Schritt MR-Daten erfasst wurden, die beiden MR-Daten für den jeweiligen K-Raum-Punkt zusammengefasst werden. Anschließend wird abhängig von den derart addierten MR-Daten das MR-Bild rekonstruiert.

- Ausgehend von denjenigen MR-Daten, welche während des ersten Schrittes erfasst wurden, wird ein erstes MR-Bild rekonstruiert. In ähnlicher Weise wird ausgehend von denjenigen MR-Daten, welche während des zweiten Schrittes erfasst wurden, eine Art zweites MR-Bild rekonstruiert. Das zu rekonstruierende MR-Bild wird dann anhand einer Kombination des ersten MR-Bildes und des zweiten MR-Bildes erstellt.

Die Rekonstruktion des MR-Bildes bei der ersten Variante und die Rekonstruktion des ersten MR-Bildes und des zweiten MR-Bildes bei der zweiten Variante können dabei beispielsweise anhand des von GRAPPA, CAIPIRINHA oder Compressed Sensing bekannten Rekonstruktionsverfahrens erfolgen.

Erfindungsgemäß wird für die Echozüge, mit welchen die K-Raum-Zeilen im ersten Schritt erfasst werden, eine erste Sequenz eingesetzt, während für die Echozüge, welchen die K-Raum-Zeilen im zweiten Schritt erfasst werden, eine zweite Sequenz eingesetzt wird. Gemäß einer erfindungsgemäßen Ausführungsform existieren folgende Varianten bezüglich eines Unterschieds zwischen diesen beiden Sequenzen:

- Die Phase des HF-Anregungspulses der zweiten Sequenz ist um 180° gegenüber der Phase des HF-Anregungspulses der ersten Sequenz verschoben. Bei dieser Variante entspricht insbesondere die Phase jedes Refokussierungspulses der zweiten Sequenz der Phase des jeweils korrespondierenden Refokussierungspulses der ersten Sequenz. Mit anderen Worten wird bei dieser Variante insbesondere die Phase der Refokussierungspulse der zweiten Sequenz nicht gegenüber der Phase der Refokussierungspulse der ersten Sequenz verschoben.

- Die Phase jedes Refokussierungspulses der zweiten Sequenz ist gegenüber der Phase des jeweils korrespondierenden Refokussierungspulses der ersten Sequenz um 180° verschoben. Bei dieser Variante entspricht insbesondere die Phase des HF-Anregungspulses der zweiten Sequenz der Phase des HF-Anregungspulses der ersten Sequenz.

Dass bei der zweiten Sequenz die Phase des HF-Anregungspulses (oder die Phase der Refokussierungspulse) um 180° gegenüber der Phase des HF-Anregungspulses (oder der Phase der Refokussierungspulse) der ersten Sequenz verschoben ist, wird bei der Rekonstruktion des MR-Bildes berücksichtigt, weist aber einen positiven Effekt bezüglich der Eliminierung der FID-Artefakte auf. Erfindungsgemäß wird die erste Variante, dass die Phase des HF-Anregungspulses der zweiten Sequenz um 180° gegenüber der Phase des HF-Anregungspulses der ersten Sequenz verschoben ist, gegenüber der zweiten Variante vorgezogen.

Erfindungsgemäß werden im ersten Schritt (ersten Average) diejenigen K-Raum-Zeilen erfasst, welche gemäß den vom Benutzer vorgenommenen Einstellungen (z.B. hinsichtlich Auflösung) zu erfassen sind. Auch die Art und Weise, in welcher diese K-Raum-Zeilen erfasst werden (z.B. das Reordering) folgt im ersten Schritt den Einstellungen des Benutzers.

Die Erfindung kann sowohl mit einem sogenannten integrierten Referenzscan als auch mit einem sogenannten separaten Referenzscan realisiert werden. Ein Referenzscan wird insbesondere für die Rekonstruktion eines MR-Bildes bei einem unterabgetasteten K-Raum (z.B. bei GRAPPA, CAIPIRINHA oder Compressed Sensing) eingesetzt. Während bei dem integrierten Referenzscan der zentrale Teil des K-Raums zusammen (integriert) mit dem Bildgebungsscan vollständig abgetastet wird, wird der zentrale Teil des K-Raums beim separaten Referenzscan mit einem dedizierten Scan (z.B. mit Echozügen, die nur den zentralen Teil erfassen) vollständig erfasst.

Bei der Erfassung der MR-Daten der K-Raum-Zeilen des zweiten Schrittes (zweiten Average) wird im Vergleich zum ersten Schritt ein erhöhter Beschleunigungsfaktor $AF_2$ verwendet, welcher folgender Gleichung (1) genügt.

$$AF_2 = AF/V \qquad (1)$$

Dabei entspricht AF dem Beschleunigungsfaktor im ersten Schritt, wobei der Beschleunigungsfaktor umso größer ist, je weniger K-Raum-Zeilen pro Echozug erfasst werden. V entspricht dem Verhältnis der Anzahl der Schnittpunkte des zweiten Schrittes zu der Anzahl der Schnittpunkte des ersten Schrittes. Bei der vorliegenden Erfindung ist dieses Verhältnis kleiner als 1, so dass $AF_2 > AF$ gilt.

Beispielsweise ist es möglich, zur Erfassung der K-Raum-Zeilen im ersten Schritt genauso viele Echozüge einzusetzen, wie bei der Erfassung der K-Raum-Zeilen im zweiten Schritt. Indem pro Echozug im zweiten Schritt im Vergleich zum ersten Schritt entsprechend weniger K-Raum-Zeilen erfasst werden, ergibt sich, dass der Beschleunigungsfaktor $AF_2$ des zweiten Schrittes entsprechend größer ist als der Beschleunigungsfaktor AF des ersten Schrittes.

Bei dem integrierten Referenzscan wird der zentrale Teil des K-Raums insbesondere sowohl während des ersten Schrittes als auch während des zweiten Schrittes komplett abgetastet. Dies führt dazu, dass bereits anhand der doppelt erfassten MR-Daten für den zentralen Teil des K-Raums die FID-Artefakte stark unterdrückt werden können.

Im Rahmen der vorliegenden Erfindung wird auch eine Magnetresonanzanlage zum Erstellen eines MR-Bildes eines vorbestimmten dreidimensionalen Volumenabschnitts eines Untersuchungsobjekts bereitgestellt. Dabei umfasst die Magnetresonanzanlage eine HF-Steuereinheit, mit welcher HF-Pulse zur Auslenkung der Magnetisierung gesteuert und generiert werden, eine Gradientensteuereinheit zur Steuerung und Schaltung notwendiger Magnetfeldgradienten, eine Bildsequenzsteuerung, welche die Abfolge der Magnetfeldgradienten und HF-Pulse und damit indirekt die Gradientensteuereinheit und die HF-Steuereinheit steuert, und eine Recheneinheit mit mindestens einer Prozessoreinheit zur Steuerung verschiedener Einheiten der Magnetresonanzanlage. Die Magnetresonanzanlage ist ausgestaltet, um MR-Daten des Volumenabschnitts mit Echozügen in einem ersten Schritt und in einem zweiten Schritt, welcher dem ersten Schritt zeitlich unmittelbar folgt, zu erfassen, um mit jedem dieser Echozüge MR-Daten mehrerer K-Raum-Zeilen zu erfassen und um ausgehend von diesen MR-Daten das MR-Bild zu rekonstruieren. Dabei verlaufen die K-Raum-Zeilen aller Echozüge parallel und senkrecht bezüglich derselben Ebene, so dass sich pro K-Raum-Zeile ein Schnittpunkt mit dieser Ebene ergibt. Die Anzahl der Schnittpunkte des ersten Schrittes ist größer als die Anzahl der Schnittpunkte des zweiten Schrittes. Die Menge der Schnittpunkte des zweiten Schrittes weist eine nicht leere Schnittmenge mit der Menge der Schnittpunkte des zweiten Schrittes auf. Der mittlere Abstand der Schnittpunkte des zweiten Schrittes ist größer als der mittlere Abstand der Schnittpunkte des ersten Schrittes.

Die Vorteile der erfindungsgemäßen Magnetresonanzanlage entsprechen dabei im Wesentlichen den Vorteilen des erfindungsgemäßen Verfahrens, welche vorab im Detail ausgeführt worden sind, so dass hier auf eine Wiederholung verzichtet wird.

Des Weiteren beschreibt die vorliegende Erfindung ein Computerprogrammprodukt, insbesondere ein Computerprogramm oder eine Software, welche man in einen Speicher einer programmierbaren Steuerung bzw. einer Recheneinheit einer Magnetresonanzanlage laden kann. Mit diesem Computerprogrammprodukt können alle oder verschiedene vorab beschriebene Ausführungsformen des erfindungsgemäßen Verfahrens ausgeführt werden, wenn das Computerprogrammprodukt in der Steuerung oder Steuereinrichtung der Magnetresonanzanlage läuft. Dabei benötigt das Computerprogrammprodukt eventuell Programmmittel, z.B. Bibliotheken und Hilfsfunktionen, um die entsprechenden Ausführungsformen der Verfahren zu realisieren. Mit anderen Worten soll mit dem auf das Computerprogrammprodukt gerichteten Anspruch insbesondere ein Computerprogramm oder eine Software unter Schutz gestellt werden, mit welcher eine der oben beschriebenen Ausführungsformen des erfindungsgemäßen Verfahrens ausgeführt werden kann bzw. welche diese Ausführungsform ausführt. Dabei kann es sich bei der Software um einen Quellcode (z.B. C++), der noch compiliert (übersetzt) und gebunden oder der nur interpretiert werden muss, oder um einen ausführbaren Softwarecode handeln, der zur Ausführung nur noch in die entsprechende Recheneinheit bzw. Steuereinrichtung zu laden ist.

Schließlich offenbart die vorliegende Erfindung einen elektronisch lesbaren Datenträger, z.B. eine DVD, ein Magnetband, eine Festplatte oder einen USB-Stick, auf welchem elektronisch lesbare Steuerinformationen, insbesondere Software (vgl. oben), gespeichert ist. Wenn diese Steuerinformationen (Software) von dem Datenträger gelesen und in eine Steuereinrichtung bzw. Recheneinheit einer Magnetresonanzanlage gespeichert werden, können alle erfindungsgemäßen Ausführungsformen des vorab beschriebenen Verfahrens durchgeführt werden.

Die Erfindung wird nachfolgend unter Bezugnahme auf die beigefügten Figuren im Detail näher erläutert.

Fig. 1 zeigt schematisch eine Magnetresonanzanlage, mit welcher erfindungsgemäß ein MR-Bild erstellt werden kann.

Fig. 2 zeigt schematisch eine Sequenz für einen Echozug, mit welchem erfindungsgemäß mehrere K-Raum-Zeilen abgetastet werden.

In Figuren 3 und 5 sind jeweils gemäß einer erfindungsgemäßen Ausführungsform die Schnittpunkte des ersten Schrittes dargestellt.

In Figuren 4 und 6 sind jeweils gemäß einer erfindungsgemäßen Ausführungsform die Schnittpunkte des zweiten Schrittes dargestellt.

Fig. 7 zeigt gemäß einer erfindungsgemäßen Ausführungsform die Schnittpunkte des ersten Schrittes.

Fig. 8 zeigt gemäß einer erfindungsgemäßen Ausführungsform die Schnittpunkte des ersten Schrittes für ein sogenanntes elliptical Scanning.

Fig. 9 zeigt gemäß einer erfindungsgemäßen Ausführungsform die Schnittpunkte des ersten Schrittes bei einer Abtastung gemäß partial Fourier.

In Fig. 10 ist der Flussplan eines erfindungsgemäßen Verfahrens dargestellt.

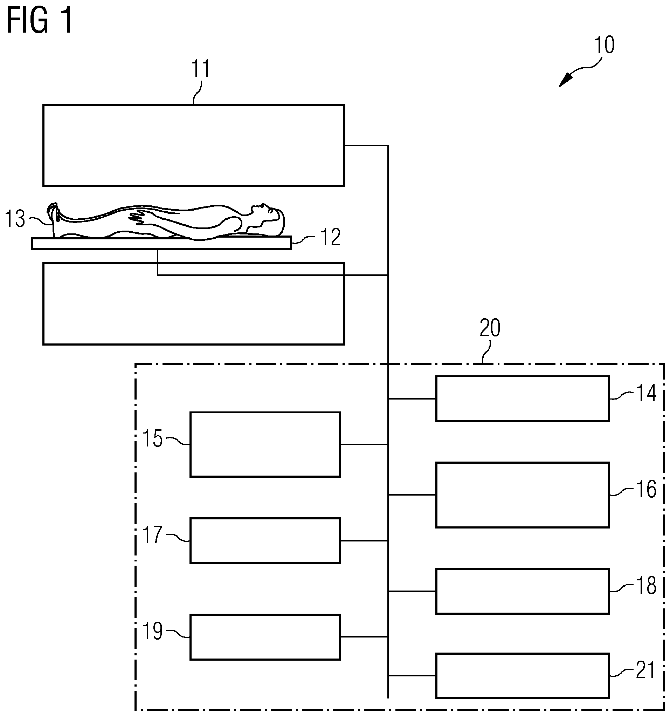

In Bezug auf Fig. 1 wird eine Magnetresonanzanlage 10 erläutert, mit der, wie nachfolgend erläutert wird, erfindungsgemäß MR-Daten erfasst und abhängig davon ein MR-Bild rekonstruiert werden kann. Die MR-Magnetresonanzanlage 10 weist einen Magneten 11 zur Erzeugung eines Polarisationsfelds B0 auf, wobei eine auf einer Liege 12 angeordnete Untersuchungsperson 13 in den Magneten 11 gefahren wird, um dort ortskodierte Magnetresonanzsignale aus der Untersuchungsperson 13 aufzunehmen. Die zur Signalaufnahme verwendeten Spulen wie eine Ganzkörperspule oder Lokalspulen sind aus Übersichtlichkeitsgründen nicht dargestellt. Durch Einstrahlen von Hochfrequenzpulsen und Schalten von Magnetfeldgradienten kann die durch das Polarisationsfeld B0 erzeugte Magnetisierung aus der Gleichgewichtslage ausgelenkt und ortskodiert werden, und die sich ergebende Magnetisierung wird von den Empfangsspulen detektiert. Wie durch Einstrahlen der HF-Pulse und durch Schalten von Magnetfeldgradienten in verschiedenen Kombinationen und Reihenfolgen MR-Bilder erzeugt werden können, ist dem Fachmann grundsätzlich bekannt und wird hier nicht näher erläutert.

Die Magnetresonanzanlage 10 weist weiterhin eine Steuereinheit 20 auf, die zur Steuerung der Magnetresonanzanlage 10 verwendet werden kann. Die Steuerung 20 weist eine Gradientensteuereinheit 15 zur Steuerung und Schaltung der notwendigen Magnetfeldgradienten auf. Eine HF-Steuereinheit 14 ist für die Steuerung und Generierung der HF-Pulse zur Auslenkung der Magnetisierung vorgesehen. Eine Bildsequenzsteuerung 16 steuert die Abfolge der Magnetfeldgradienten und HF-Pulse und damit indirekt die Gradientensteuereinheit 15 und die HF-Steuereinheit 14. Über eine Eingabeeinheit 17 kann eine Bedienperson die Magnetresonanzanlage steuern, und auf einer Anzeigeeinheit 18 können MR-Bilder und sonstige zur Steuerung notwendigen Informationen angezeigt werden. Eine Recheneinheit 19 mit mindestens einer Prozessoreinheit (nicht gezeigt) ist vorgesehen zur Steuerung der verschiedenen Einheiten in der Steuereinheit 20. Weiterhin ist eine Speichereinheit 21 vorgesehen, in der beispielsweise Programmmodule bzw. Programme abgespeichert sein können, die, wenn sie von der Recheneinheit 19 bzw. ihrer Prozessoreinheit ausgeführt werden, den Ablauf der Magnetresonanzanlage steuern können. Die Recheneinheit 19 ist, wie nachfolgend erläutert wird, ausgebildet, erfindungsgemäß MR-Daten zu erfassen und ausgehend davon ein MR-Bild zu rekonstruieren.

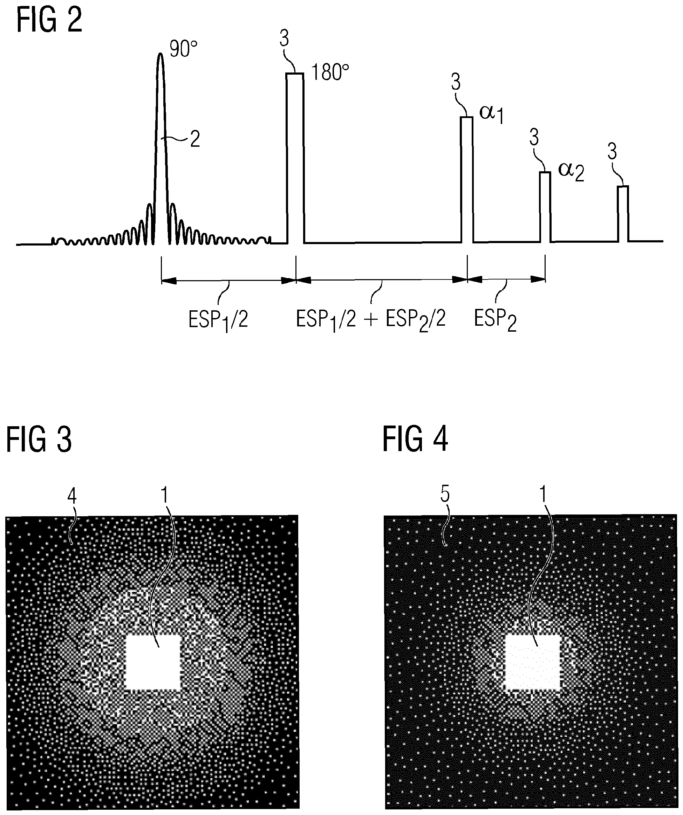

In Fig. 2 ist eine erfindungsgemäße Sequenz für einen Echozug dargestellt.

Ein selektiver HF-Anregungspuls 2 (d.h. gleichzeitig mit dem HF-Anregungspuls wird ein Selektionsgradient geschaltet) wird eingestrahlt, welchem nach der Zeitspanne $ESP_1/2$ ein erster Refokussierungspuls 3 folgt. Diesem ersten Refokussierungspuls 3 folgt ein zweiter Refokussierungspuls 3 nach der Zeitspanne (ESP1/2 + ESP2/2), welchem wiederum ein dritter Refokussierungspuls 3 nach der Zeitspanne $ESP_2$ folgt. Alle weiteren Refokussierungspulse 3 werden jeweils die Zeitspanne $ESP_2$ nach ihrem vorhergehenden Refokussierungspuls 3 eingestrahlt. Dabei ist $ESP_1$ ein von dem HF-Anregungspuls 2 abhängiger Echoabstand, während $ESP_2$ ein von dem ersten Refokussierungspuls 3 abhängiger Echoabstand ist. Die Refokussierungspulse 3 sind nicht selektiv.

Nach jedem Refokussierungspuls 3 werden die MR-Daten einer K-Raum-Zeile ausgelesen. Mit einem Echozug können 120 oder mehr nicht selektive Refokussierungspulse 3 eingestrahlt und damit 120 oder mehr K-Raum-Zeilen ausgelesen werden, wobei der Flipwinkel $\alpha$ der nicht selektiven Refokussierungspulse 3 entsprechend variiert wird. Das dargestellte Sequenzdiagramm kann einer SPACE-Sequenz entsprechen. In Figuren 3 bis 9 sind erfindungsgemäß sogenannte Abtastmasken (Sampling Masken) für den ersten oder zweiten Schritt dargestellt. Dabei beschreibt jede Abtastmaske die K-Raum-Zeilen, deren MR-Daten während des jeweiligen Schritts erfindungsgemäß erfasst werden. Jede erfasste K-Raum-Zeile steht dabei senkrecht auf einer Ebene, welche der Zeichenebene der Figuren 3 bis 9 entspricht. Jeder Punkt der jeweiligen Abtastmaske entspricht somit einem Schnittpunkt 4; 5 der jeweiligen K-Raum-Zeile mit dieser Ebene.

In Fig. 3 ist die Abtastmaske des ersten Schrittes für einen integrierten Referenzscan dargestellt. Man erkennt, dass in diesem ersten Schritt der zentrale Teil 1 des K-Raums vollständig abgetastet wird.

In Fig. 4 ist die Abtastmaske des zweiten Schrittes für eine Ausführungsform dargestellt, bei welcher die Abtastmaske aus Fig. 3 für den ersten Schritt eingesetzt wird. Man erkennt, dass bei dieser Ausführungsform der zentrale Teil 1 des K-Raums auch im zweiten Schritt vollständig abgetastet wird.

Vergleicht man die Schnittpunkte 4 des ersten Schrittes (siehe Fig. 3) mit den Schnittpunkten 5 des zweiten Schrittes (siehe Fig. 4), erkennt man, dass der mittlere Abstand von benachbarten Schnittpunkten 4 im ersten Schritt kleiner als der mittlere Abstand zwischen benachbarten Schnittpunkten 5 im zweiten Schritt ist. Anders ausgedrückt ist die Dichte der Schnittpunkte 4 in Fig. 3 (erster Schritt) größer als die Dichte der Schnittpunkte 5 in Fig. 4 (zweiter Schritt).

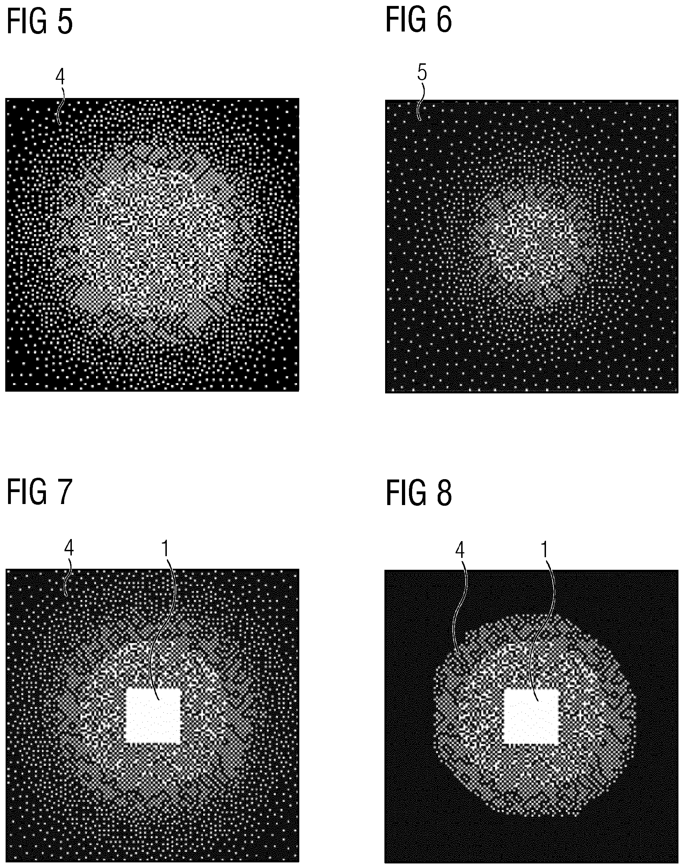

In ähnlicher Weise wie bei den Figuren 3 und 4 stellen die Figuren 5 und 6 die Abtastmaske des ersten Schrittes (siehe Fig. 5) und die Abtastmaske des zweiten Schrittes (siehe Fig. 6) für eine erfindungsgemäße Ausführungsform dar. Auch bei dieser Ausführungsform gilt, dass der mittlere Abstand benachbarter Schnittpunkte 5 im zweiten Schritt (Fig. 6) größer ist als der mittlere Abstand zwischen benachbarten Schnittpunkten 4 im ersten Schritt (Fig. 5).

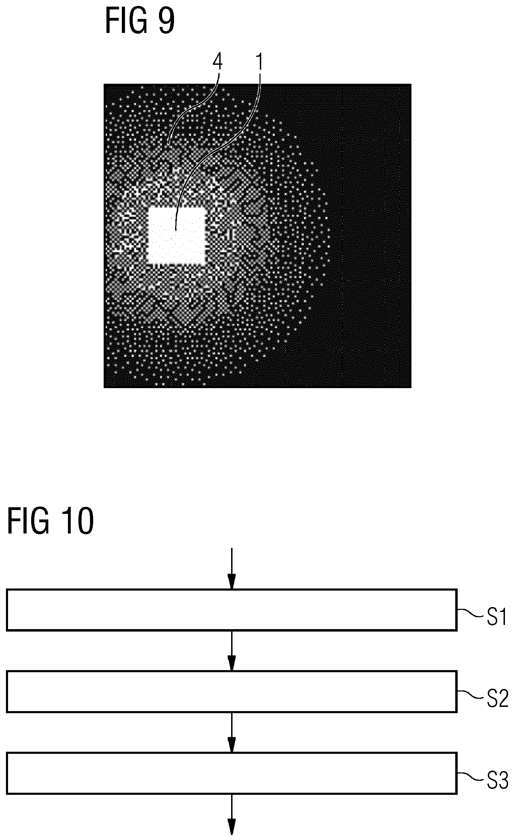

Figuren 7 bis 9 stellen Abtastmasken des ersten Schrittes für erfindungsgemäße Ausführungsformen dar. Man erkennt, dass bei allen drei Ausführungsformen der zentrale Teil 1 des K-Raums im ersten Schritt vollständig abgetastet wird. Dabei zeigt die in Fig. 8 dargestellte Abtastmaske eine auch als "Elliptical Scanning" bekannte Anordnung der abzutastenden K-Raum-Zeilen oder Schnittpunkte 4. Das heißt, die Schnittpunkte 4 folgen einer Art elliptischer Spirale um das K-Zentrum herum. Die in Fig. 9 dargestellte Abtastmaske gehört zu einer erfindungsgemäßen Variante, welche auch als partial Fourier bekannt ist und bei welcher im Wesentlichen nur eine Hälfte des K-Raums abgetastet wird.

Die (nicht dargestellten) Abtastmasken des zweiten Schrittes, welche mit den entsprechenden Abtastmasken des ersten Schrittes, die in Figuren 7 bis 9 dargestellt sind, korrespondieren, weisen deutlich weniger Schnittpunkte auf, als die jeweils zugehörige Abtastmaske des ersten Schrittes. Dennoch ist erfindungsgemäß die Ausdehnung der Abtastmaske des zweiten Schrittes im Wesentlichen genauso groß wie die Ausdehnung der zugehörigen Abtastmaske des ersten Schrittes. Da die Ausdehnung der Abtastmaske des zweiten Schrittes im Wesentlichen genauso groß ist wie die Ausdehnung der Abtastmaske des ersten Schrittes und da die Anzahl der Schnittpunkte des ersten Schrittes größer als die Anzahl der Schnittpunkte des zweiten Schrittes ist, ist der mittlere Abstand benachbarter Schnittpunkte beim zweiten Schritt größer als beim ersten Schritt und die Dichte der Schnittpunkte ist beim ersten Schritt größer als beim zweiten Schritt. Anders ausgedrückt wird erfindungsgemäß im zweiten Schritt zwar nahezu derselbe Bereich des K-Raums abgetastet wie beim ersten Schritt, wobei aber pro Fläche im zweiten Schritt weniger K-Raum-Zeilen abgetastet werden als im ersten Schritt.

Erfindungsgemäß gilt allgemein (d.h. für die Figuren 3, 5, 7, 8 und 9), dass die im ersten Schritt erfassten K-Raum-Zeilen für das jeweils gewählte Bilderstellungsverfahren (z.B. GRAPPA, CAIPIRINHA, Compressed Sensing) ausreichend viele MR-Daten bereitstellen, um nur ausgehend von diesen MR-Daten (d.h. ohne die im zweiten Schritt erfassten MR-Daten) ein MR-Bild mit einer vorbestimmten Qualität zu rekonstruieren. Die im zweiten Schritt erfassten MR-Daten dienen somit insbesondere nur der Unterdrückung der FID-Artefakte, welche im rekonstruierten MR-Bild auftreten würden, wenn nur die MR-Daten des ersten Schrittes zur Rekonstruktion des MR-Bildes herangezogen würden.

In Fig. 10 ist der Flussplan eines erfindungsgemäßen Verfahrens dargestellt.

In einem ersten Verfahrensschritt S1, welcher dem vorab beschriebenen ersten Schritt entspricht, werden MR-Daten mittels Echozügen erfasst. In ähnlicher Weise werden in einem zweiten Verfahrensschritt S2, welcher dem vorab beschriebenen zweiten Schritt entspricht, MR-Daten mittels Echozügen erfasst. Der mittlere Abstand von benachbarten K-Raum-Zeilen, welche im zweiten Verfahrensschritt S2 abgetastet werden, ist dabei größer als der mittlere Abstand von benachbarten K-Raum-Zeilen, welche im ersten Verfahrensschritt S1 abgetastet werden. Anhand der erfassten MR-Daten wird im dritten Verfahrensschritt S3 ein MR-Bild rekonstruiert.

**Patentansprüche**

1. Verfahren zur Erstellung eines MR-Bildes eines vorbestimmten dreidimensionalen Volumenabschnitts eines Untersuchungsobjekts (13),
   wobei MR-Daten des Volumenabschnitts mittels Echozügen (2, 3) in einem ersten Schritt und in einem zweiten Schritt erfasst werden,
   wobei jeder der Echozüge (2, 3) MR-Daten mehrerer K-Raum-Zeilen erfasst,
   wobei die K-Raum-Zeilen aller Echozüge parallel und dabei senkrecht bezüglich einer Ebene verlaufen, so dass sich pro K-Raum-Zeile ein Schnittpunkt (4; 5) mit der Ebene ergibt,
   wobei die Anzahl der Schnittpunkte (4) des ersten Schrittes größer als die Anzahl der Schnittpunkte (5) des zweiten Schrittes ist,
   wobei die Menge der Schnittpunkte (5) des zweiten Schrittes eine nicht leere Schnittmenge mit der Menge der Schnittpunkte (4) des ersten Schrittes aufweist,
   wobei der mittlere Abstand der Schnittpunkte (5) des zweiten Schrittes größer als der mittlere Abstand der Schnittpunkte (4) des ersten Schrittes ist, und
   wobei ausgehend von den MR-Daten das MR-Bild rekonstruiert wird.

2. Verfahren nach Anspruch 1,
   **dadurch gekennzeichnet,**
   **dass** der mittlere Abstand der Schnittpunkte (5) des zweiten Schrittes um einen Faktor größer als der mittlere Abstand der Schnittpunkte (4) des ersten Schrittes ist, und
   **dass** der Faktor umso größer ist, je größer das Verhältnis zwischen der Anzahl der Schnittpunkte (4) des ersten Schrittes zu der Anzahl der Schnittpunkte (5) des zweiten Schrittes ist.

3. Verfahren nach einem der vorhergehenden Ansprüche,
   **dadurch gekennzeichnet,**
   **dass** ein zentraler Teil (1) des K-Raums während des ersten Schritts vollständig erfasst wird.

4. Verfahren nach Anspruch 3,
   **dadurch gekennzeichnet,**
   **dass** der zentrale Teil (1) des K-Raums mit Echozügen (2, 3) erfasst wird, welche ausschließlich MR-Daten des zentralen Teils (1) erfassen.

5. Verfahren nach Anspruch 3,
   **dadurch gekennzeichnet,**
   **dass** der zentrale Teil (1) des K-Raums mit Echozügen (2, 3) erfasst wird, welche jeweils sowohl MR-Daten des zentralen Teils (1) des K-Raums als auch MR-Daten außerhalb des zentralen Teils (1) des K-Raums erfassen.

6. Verfahren nach einem der Ansprüche 3-5,
   **dadurch gekennzeichnet,**
   **dass** der zentrale Teil (1) des K-Raums auch während des zweiten Schritts vollständig erfasst wird.

7. Verfahren nach einem der vorhergehenden Ansprüche,
   **dadurch gekennzeichnet,**
   **dass** die Menge der Schnittpunkte (5) des zweiten Schrittes eine Teilmenge der Menge der Schnittpunkte (4) des ersten Schrittes ist.

8. Verfahren nach einem der Ansprüche 1-6,
   **dadurch gekennzeichnet,**
   **dass** sich die Menge der Schnittpunkte (5) des zweiten Schrittes nur außerhalb des zentralen Teils (1) des K-Raums von der Menge der Schnittpunkte (4) des ersten Schrittes unterscheidet.

9. Verfahren nach einem der vorhergehenden Ansprüche,
   **dadurch gekennzeichnet,**
   **dass** das Rekonstruieren des MR-Bildes umfasst,
   **dass** die MR-Daten des ersten Schrittes und die MR-Daten des zweiten Schrittes addiert werden, und
   **dass** ausgehend von den addierten MR-Daten das MR-Bild rekonstruiert wird.

10. Verfahren nach einem der Ansprüche 1-8,
    **dadurch gekennzeichnet,**
    **dass** das Rekonstruieren des MR-Bildes umfasst,
    **dass** ausgehend von den MR-Daten des ersten Schrittes ein erstes MR-Bild rekonstruiert wird,
    **dass** ausgehend von den MR-Daten des zweiten Schrittes ein zweites MR-Bild rekonstruiert wird, und
    **dass** das MR-Bild durch eine Kombination des ersten MR-Bildes und des zweiten MR-Bildes erstellt wird.

11. Verfahren nach einem der vorhergehenden Ansprüche,
    **dadurch gekennzeichnet,**
    **dass** eine erste Sequenz zum Erfassen jedes der Echozüge (2, 3) in dem ersten Schritt eingesetzt wird,

**dass** eine zweite Sequenz zum Erfassen jedes der Echozüge (2, 3) in dem zweiten Schritt eingesetzt wird,

**dass** entweder die Phase des HF-Anregungspulses (2) der ersten Sequenz um 180° gegenüber der Phase des HF-Anregungspulses (2) der zweiten Sequenz verschoben ist oder dass die Phase der Refokussierungspulse (3) der ersten Sequenz um 180° gegenüber der Phase der Refokussierungspulse (3) der zweiten Sequenz verschoben ist.

12. Magnetresonanzanlage zum Erstellen eines MR-Bildes eines vorbestimmten dreidimensionalen Volumenabschnitts eines Untersuchungsobjekts (13),

wobei die Magnetresonanzanlage (10) eine HF-Steuereinheit (14), eine Gradientensteuereinheit (15), eine Bildsequenzsteuerung (16) und eine Recheneinheit (19) umfasst, und

wobei die Magnetresonanzanlage (10) ausgestaltet ist,

um MR-Daten des Volumenabschnitts mittels Echozügen (2, 3) in einem ersten Schritt und in einem zweiten Schritt zu erfassen, und

um mit jedem der Echozüge (2, 3) MR-Daten mehrerer K-Raum-Zeilen zu erfassen,

wobei die K-Raum-Zeilen aller Echozüge parallel und dabei senkrecht bezüglich einer Ebene verlaufen, so dass sich pro K-Raum-Zeile ein Schnittpunkt (4; 5) mit der Ebene ergibt,

wobei die Anzahl der Schnittpunkte (4) des ersten Schrittes größer als die Anzahl der Schnittpunkte (5) des zweiten Schrittes ist,

wobei die Menge der Schnittpunkte (5) des zweiten Schrittes eine nicht leere Schnittmenge mit der Menge der Schnittpunkte (4) des zweiten Schrittes aufweist, und

wobei der mittlere Abstand der Schnittpunkte (5) des zweiten Schrittes größer als der mittlere Abstand der Schnittpunkte (4) des ersten Schrittes ist,

wobei die Magnetresonanzanlage (10) ausgestaltet ist, um ausgehend von den MR-Daten das MR-Bild zu rekonstruieren.

13. Magnetresonanzanlage nach Anspruch 12,
**dadurch gekennzeichnet,**
**dass** die Magnetresonanzanlage (10) zur Durchführung des Verfahrens nach einem der Ansprüche 1-12 ausgestaltet ist.

14. Computerprogrammprodukt, welches ein Programm umfasst und direkt in einen Speicher einer programmierbaren Steuereinrichtung (20) einer Magnetresonanzanlage (10) ladbar ist, mit Programm-Mitteln, um alle Schritte des Verfahrens nach einem der Ansprüche 1-11 auszuführen, wenn das Programm in der Steuereinrichtung (20) der Magnetresonanzanlage (10) ausgeführt wird.

15. Elektronisch lesbarer Datenträger mit darauf gespeicherten elektronisch lesbaren Steuerinformationen, welche derart ausgestaltet sind, dass sie bei Verwendung des Datenträgers in einer Steuereinrichtung (20) einer Magnetresonanzanlage (10) das Verfahren nach einem der Ansprüche 1-11 durchführen.

FIG 1

FIG 2

$ESP_1/2$  $ESP_1/2 + ESP_2/2$  $ESP_2$

FIG 3

FIG 4

FIG 5

FIG 6

FIG 7

FIG 8

FIG 9

FIG 10

Europäisches
Patentamt

European
Patent Office

Office européen
des brevets

# EUROPÄISCHER RECHERCHENBERICHT

Nummer der Anmeldung

EP 18 18 5271

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | HENRY SZU-MENG CHEN ET AL.: "3D Compressed Sensing CPMG with Group-Sparse Reconstruction for Myelin Water Imaging", PROCEEDINGS OF THE INTERNATIONAL SOCIETY FOR MAGNETIC RESONANCE IN MEDICINE, ISMRM, JOINT ANNUAL MEETING ISMRM-ESMRMB, MILAN, ITALY, 10-16 MAY 2014, Nr. 4225, 28. April 2014 (2014-04-28), XP040670999, * das ganze Dokument * | 1-15 | INV. G01R33/561 G01R33/48 |
| X | JOHN P. MUGLER: "Optimized three-dimensional fast-spin-echo MRI : Optimized 3D Fast-Spin-Echo MRI", JOURNAL OF MAGNETIC RESONANCE IMAGING, Bd. 39, Nr. 4, 8. Januar 2014 (2014-01-08), Seiten 745-767, XP055496935, US ISSN: 1053-1807, DOI: 10.1002/jmri.24542 * Abbildungen 8,13,15 * * Seite 755 * * Seite 760 - Seite 763 * | 1-15 | |
| X | WO 2018/096073 A1 (KONINKLIJKE PHILIPS NV [NL]) 31. Mai 2018 (2018-05-31) * Abbildung 3 * * Seite 12 - Seite 13 * | 1-10, 12-15 | RECHERCHIERTE SACHGEBIETE (IPC) G01R |
| X | US 2016/313431 A1 (BECK GABRIELE MARIANNE [NL] ET AL) 27. Oktober 2016 (2016-10-27) * Anspruch 1 * * Absatz [0067] - Absatz [0068] * | 1-10, 12-15 | |

-/--

Der vorliegende Recherchenbericht wurde für alle Patentansprüche erstellt

| Recherchenort | Abschlußdatum der Recherche | Prüfer |
|---|---|---|
| München | 23. Januar 2019 | Durst, Markus |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

    ......................................................................
& : Mitglied der gleichen Patentfamilie, übereinstimmendes Dokument

EPO FORM 1503 03.82 (P04C03)

Seite 1 von 2

Europäisches Patentamt

European Patent Office

Office européen des brevets

# EUROPÄISCHER RECHERCHENBERICHT

**Nummer der Anmeldung**

EP 18 18 5271

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | ANAGHA DESHMANE ET AL: "Parallel MR imaging", JOURNAL OF MAGNETIC RESONANCE IMAGING, Bd. 36, Nr. 1, 13. Juni 2012 (2012-06-13), Seiten 55-72, XP055546603, US ISSN: 1053-1807, DOI: 10.1002/jmri.23639 * Abschnitt "SENSITIVITY ENCODING (SENSE)" * * Abschnitt "GENERALIZED AUTOCALIBRATING PARTIALLY PARALLEL ACQUISITION (GRAPPA)" * * Abschnitt "CLINICAL APPLICATIONS OF PARALLEL IMAGING" * * Abbildungen 5,9 * ----- | 1,3-5,7, 10,12-15 | |

**RECHERCHIERTE SACHGEBIETE (IPC)**

Der vorliegende Recherchenbericht wurde für alle Patentansprüche erstellt

| Recherchenort | Abschlußdatum der Recherche | Prüfer |
|---|---|---|
| München | 23. Januar 2019 | Durst, Markus |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 18 18 5271

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

23-01-2019

| Im Recherchenbericht angeführtes Patentdokument | Datum der Veröffentlichung | Mitglied(er) der Patentfamilie | | Datum der Veröffentlichung |
|---|---|---|---|---|
| WO 2018096073 A1 | 31-05-2018 | KEINE | | |
| US 2016313431 A1 | 27-10-2016 | CN | 106030329 A | 12-10-2016 |
| | | EP | 3080633 A1 | 19-10-2016 |
| | | JP | 2016539722 A | 22-12-2016 |
| | | US | 2016313431 A1 | 27-10-2016 |
| | | WO | 2015086415 A1 | 18-06-2015 |

EPO FORM P0461

Für nähere Einzelheiten zu diesem Anhang : siehe Amtsblatt des Europäischen Patentamts, Nr.12/82